# EUROPEAN PATENT APPLICATION

(11) **EP 1 508 918 A1**
(43) Date of publication of application: **23.02.2005**
(21) Application number: 03292084.5
(22) Date of filing: 22.08.2003
(51) Int. Cl.: H01L 27/02, H01L 27/07

(54) **Semiconductor power device**

(71) Applicant: Freescale Semiconductor, Inc., Austin, Texas 78735 (US)
(72) Inventor: Lochot, Christophe, 31500 Toulouse Midi-Pyrenees (FR); Besse, Patrice, 31300 Toulouse (FR); Laine, Jean Philippe, 31100 Toulouse Midi Pyrenees (FR); Bafleur, Marise, 31320 Castanet-Tolosan Midi-Pyrenees (FR)
(74) Representative: Wharmby, Martin Angus

(57) **Abstract**

A semiconductor power device comprising an isolation section forming a power transistor for driving an inductive load and a bipolar transistor for protecting the power device, the power transistor having a first semiconductor region for coupling to the inductive load, the first region arranged to form a PN junction with a second region and wherein the bipolar transistor is arranged to divert current from a third region that forms a PN junction with the second region upon forward biasing of the PN junction formed between the first region and the second region.

## Description

The present invention relates to a protective device for a semiconductor power device.

Semiconductor power devices are frequently used to drive inductive loads. However, an inductive discharge applied to the output of a power transistor can cause the output junction to become forward biased resulting in a parasitic bipolar transistor being formed where the output junction becomes an emitter of the parasitic bipolar transistor, the substrate of the power device acts as the base and neighbouring PN junction regions act as the collector.

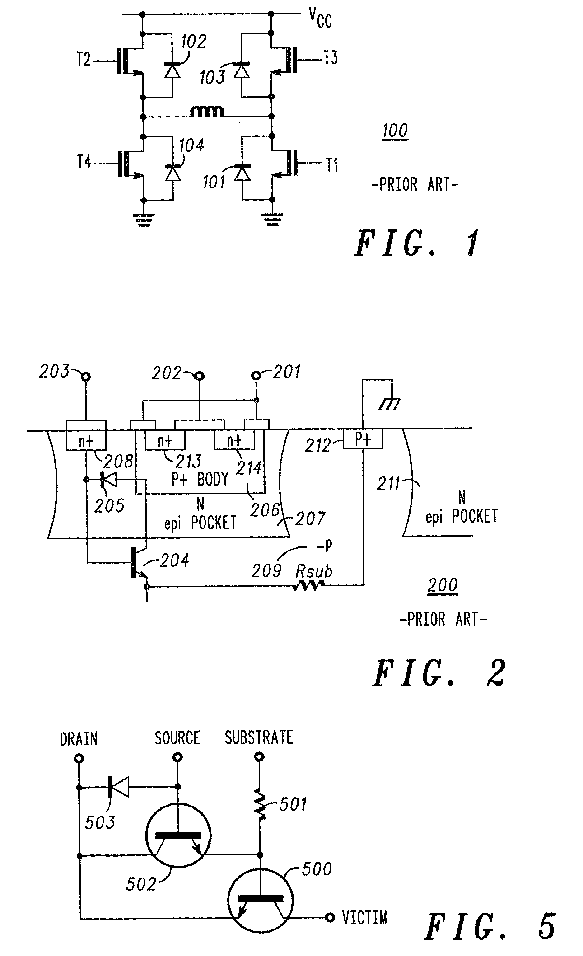

This is further illustrated in figure 1, which shows four power transistors configured in an H-bridge circuit 100 for driving an inductive load L. A drain of a transistor T2 and a drain of a transistor T3 are connected to a voltage source Vcc. A source of a transistor T4 and a source of a transistor T1 are connected to a ground voltage reference. A source of the transistor T2 and a drain of the transistor T4 are connected to a first end of the inductive load L and a source of the transistor T3 and a drain of the transistor T1 are connected to a second end of the inductive load L. Each of the power transistors T1, T2, T3, T4 have a respective body diode 101, 102, 103, 104 connected between the source and drain that are intrinsic to the structure of the power transistors T1, T2, T3, T4.

The four power transistors T1, T2, T3, T4 of the H-bridge circuit 100 control the delivery of current to the inductive load L. The power transistors T1, T2, T3, T4 are alternatively switched on and off to permit current to flow from the voltage source Vcc to the ground voltage reference. For example, when the transistors T1 and T2 are switched on and the transistors T3 and T4 are switched off, current will flow from the voltage source Vcc through the transistor T2, the inductive load L, and the transistor T1 to the ground voltage reference. If the transistors T3 and T4 are switched on and the transistors T1 and T2 are switched off, current will flow from the voltage source Vcc through the transistor T3, the inductive load L, and the transistor T4 to the ground voltage reference.

When the power transistors T1, T2, T3, T4 are switched on or off to change the direction of current in the inductive load L the inductive load L will react by applying a transient voltage to oppose the changing voltage where, as stated above, the transient voltage can cause a parasitic bipolar transistor to be triggered on. For example, if the transistors T3 and T4 are conducting current through the inductive load L and are switched off, the inductive load L will react to maintain the current. Specifically, the drain of the transistor T1 will be driven below the ground voltage reference to draw current through the transistor T1, and the source of the transistor T2 will be driven above the voltage source Vcc to force current through the transistor T2.

This is more clearly illustrated in figure 2, which shows a cross sectional view of a conventional N-channel power transistor 200 of the type used for the transistors T1, T2, T3, T4. The power transistor 200 has a gate 201, source 202 and drain 203 terminals, a parasitic NPN 204 transistor and a body diode 205.

The body diode 205 is intrinsic to the structure of the power transistor 200 and comprises a P+ body region 206 and an N type epitaxial (epi) region 207.

The parasitic NPN transistor 204 is comprised of an N+ drain region 208 and the epi region 207 acting as an emitter, a P- substrate 209 acting as a base, where a resistance formed by the P- substrate 209 is represented by resistor Rsub and a neighbouring epi-pocket 211 acting as a collector. A P+ region 212 links the P-substrate 209 with a ground voltage reference at the surface of the P- substrate 209.

Normal operation of the power transistor 200 occurs when a voltage at the drain 203 of the power transistor 200 exceeds a voltage at the source 202, and a positive voltage is applied to the gate terminal 201, where the positive voltage applied to the gate terminal 201 exceeds a threshold voltage of the power transistor 200. On occurrence of these events current flows from the drain terminal 203 and the N+ drain region 208 to two N+ source regions 213, 214 through an N type channel induced in the P+ body region 206. When the voltage applied to the gate terminal 201 falls below the threshold voltage the transistor 200 is turned off and current through the power transistor 200 stops.

However, the operation of the NPN parasitic transistor 204 can come into effect when applying a voltage to the drain terminal 203 below a ground voltage reference (as can occur when using a power transistor to drive an inductive load, as described above).

On occurrence of this event the body diode 205 becomes forward biased and allows a recirculation current to pass from the source terminal 202 and the P+ region 206 to the N+ drain region 208 and the drain terminal 203. Additionally, the base emitter junction of the parasitic transistor 204 becomes forward biased resulting in the delivery of current to the P- substrate 209 and other epi pockets that act as a collector for the parasitic transistor 204.

However, parasitic substrate currents created by a parasitic transistor can not only cause the power device to malfunction but can cause an increase in power dissipation and result in over heating.

One solution to this problem, as disclosed in US 5 545 917, is to use a protective bipolar transistor coupled to the power device to control the biasing of the parasitic transistor to reduce the flow of current through the parasitic bipolar transistor.

However, this solution results in an increase in area of the component used to drive the inductive load. Further, the power device requires electro-static discharge ESD protection causing a further increase in size of the component.

It is desirable to improve this situation.

In accordance with a first aspect of the present invention there is provided a semiconductor MOS power device according to claim 1.

This provides the advantage of allowing an integrated power device provide protection against parasitic currents and improve ESD robustness while consuming less silicon area.

In accordance with a second aspect of the present invention there is provided a semiconductor MOS power device according to claim 5.

An embodiment of the invention will now be described, by way of example, with reference to the drawings, of which:
Figure 1 shows a H-bridge circuit for controlling an inductive load according to the prior art;
Figure 2 shows a cross sectional view of an N-channel power transistor according to the prior art;
Figure 3 shows a semiconductor MOS power device according to a first embodiment of the present invention;
Figure 4 shows an equivalent circuit for the semiconductor MOS power device shown in figure 3;
Figure 5 shows an alternative equivalent circuit for the semiconductor MOS power device shown in figure 3;
Figure 6 illustrates current flow in the semiconductor MOS power device shown in figure 3 when a first voltage, above -0.6V, is applied to the power device;
Figure 7 illustrates current flow in the semiconductor MOS power device shown in figure 3 when a second voltage, between -0.6V and -1V, is applied to the power device;
Figure 8 illustrates current flow in the semiconductor MOS power device shown in figure 3 when a third voltage, below -1V, is applied to the power device;
Figure 9 illustrates current flow in the semiconductor MOS power device shown in figure 3 when an ESD voltage is applied to the power device;
Figure 10 shows a semiconductor MOS power device according to a second embodiment of the present invention;
Figure 11 shows an equivalent circuit for the semiconductor MOS power device shown in figure 10;
Figure 12 illustrates current flow in the semiconductor MOS power device shown in figure 10 when an ESD voltage is applied to the power device.

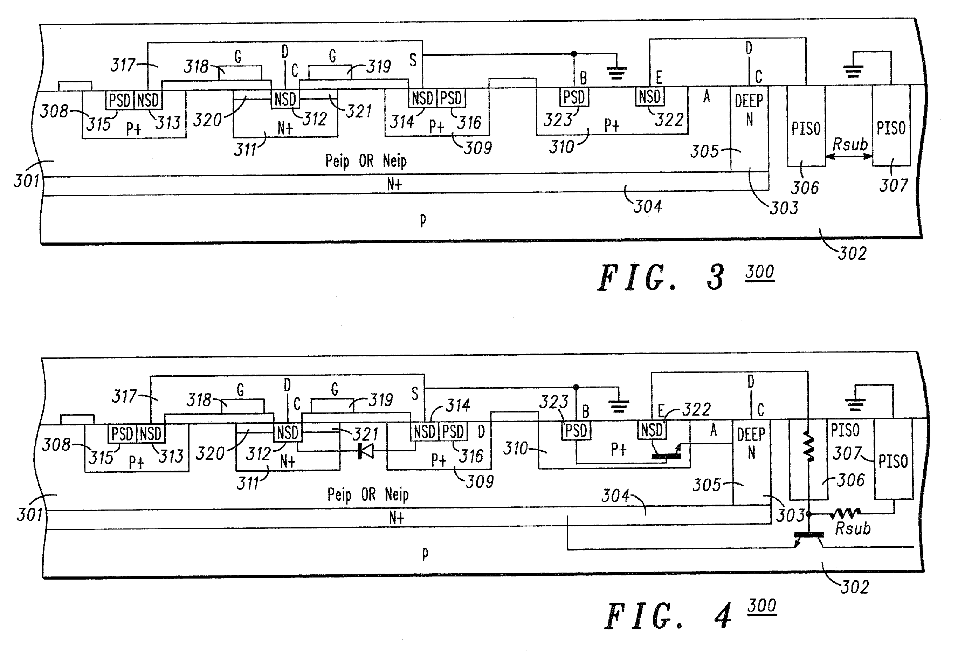

Figure 3 shows a semiconductor MOS power device 300. The semiconductor power device 300 has an epitaxial layer 301 formed over a P substrate 302. The epitaxial layer 301 can be either N or P (i.e. either a P-epi or N-epi layer), however in this embodiment the epitaxial layer is an N-epi layer.

A deep drain region 303 is formed by (i) a buried layer 304 that is located at the interface of the substrate 302 and the epitaxial layer 301 and (ii) an annular deep diffusion region 305 extending from the surface of the epitaxial layer 301 down to the buried layer 304 to form an isolated region (i.e. an island region) within the epitaxial layer.

External to the island region is formed a first isolation region 306 (i.e. a first Piso region) and a second isolation region 307 (i.e. a second Piso region) where the first Piso region 306 is separated from the second Piso region 307 by a distance Wsub. The distance Wsub determines the substrate resistance Rsub between the first Piso region 306 and the second Piso region 307. For the purpose of the present embodiment the boundary of the MOS power device is defined by the second Piso region 307.

Formed within the island region is a first P+ well region 308, a second P+ well region 309, a third P+ well region 310 and an N+ well region 311.

Although the present embodiment shows three P+ wells and an N+ well a power device may have many P+ well region/N+ well region/P+ well region, which form the fingers of the power device 300. For example, this structure could be repeated 20 times to be able to have many amps in the power device.

The N+ well region 311 has an NSD region 312 (i.e. an N+ layer for device ohmic contact) that forms a shallow drain region.

Both the first P+ well region 308 and second P+ well region 309 have an NSD region 313, 314 and a PSD region 315, 316 (i.e. a P+ layer for device ohmic contact). The NSD regions 313, 314 of the first P+ well region and the second P+ well region 309 form a shallow source region that are coupled together by means of a metal layer 317. In both P+ well regions 308, 309, the PSD region 315, 316 is short-circuited to the NSD region of the same well by means of a metal layer that forms the source of the power device 300 (not shown). The first Pwell region 308, the N+ well region 311 and the second P+ well region 309 form a finger of the power device 300 (which is symmetrical). This structure is repeated as many times as needed to assume the level of current in the power device.

A first electrode 318 and a second electrode 319 are positioned above the N+ well region 311, separated by an oxide layer 320, 321, and a portion of the epitaxial layer to form a first gate electrode 320 and second gate electrode 321 respectively.

The third P+ well region 310 has a NSD 322 and a PSD region 323. The P+ well region 310 is connected to the source with the metal layer 317 via the PSD region 323.

The third P+ well region 310 is separated from the annular deep diffusion region 305 by a length L.

The PSD region 323 of the third P+ well region 310 is arranged to be coupled to a reference voltage, for example ground, in addition to the shallow source regions 313, 314 of the first P+ well region 308 and the second P+ well region 309.

The NSD region 322 of the third P+ well region 310 is arranged to be coupled to the first Piso region 306.

The second Piso region 307 is arranged to be coupled to ground.

The deep drain region 305, the shallow drain region 312, the shallow source regions 313, 314, the first gate electrode 320 and the second gate electrode 321 form the junctions of a power transistor.

The deep drain region 305, the shallow drain region 312, the third P+ well region 310 and the NSD region 322 of the third P+ well region 310 form the junctions of a protective bipolar device, as described below, where the deep drain region 305 and the shallow drain region 312 form the collector, the third P+ well region 310 forms the base, and the NSD region 322 of the third P+ well region 310 forms the emitter.

Normal operation of the power transistor occurs when a voltage applied to the deep drain 305 and shallow drain region 312 exceeds a voltage at the source and a positive voltage is applied to the first gate terminal 318 and the second gate terminal 319, where the positive voltage applied to the first gate terminal 318 and second gate terminal 319 exceeds a threshold voltage of the power transistor. On occurrence of these events current flows from the deep drain region 305 and shallow drain region 312 and the N+ well region 311 to the NSD regions 313, 314 in the first P+ well region 308 and the second P+ well region 309 through an N type channel induced in the N epi layer 301.

Figure 4 illustrates the power device 300 shown in figure 3 where equivalent circuit components have been superimposed onto the semiconductor regions shown in figure 3 to more clearly illustrate the operation of the semiconductor power device 300 when either a voltage is applied to the source terminal that exceeds the voltage at the drain or a voltage is applied to the drain terminal that is below the ground voltage reference. Figure 4 shows the power transistor body diode formed between the second P+ well region 309 and the N epi layer 301 and the protective bipolar transistor formed between the deep drain region 305, the shallow drain region 312, the third P+ well region 310 and the NSD region 312 of the third P+ well 310. Additionally, figure 4 illustrates the parasitic transistor formed between the first Piso layer 306, the buried layer 304 and other N regions (i.e. victims), where the Piso layer 306 forms the base, the buried layer 304 forms the emitter and the victims form the collector.

An equivalent circuit, similar to the figures depicted in figure 3 and figure 4, is shown in figure 5 that more clearly illustrates how the base of the parasitic transistor 500 is coupled to ground via Rsub 501 (i.e. the resistance defined by the distance Wsub), the emitter is coupled to the drain and the collector is coupled to a victim. The base of the protective transistor 502 is coupled to the source of the power device (not shown), the collector is coupled to the drain and the emitter is coupled to the base of the parasitic transistor 500. The body diode 503 is coupled between the base of the protective transistor 502 and the drain.

The operation of the semiconductor power device 300 will now be described during the period when the drain voltage goes below a ground voltage reference, which in this embodiment is taken to be 0 volts.

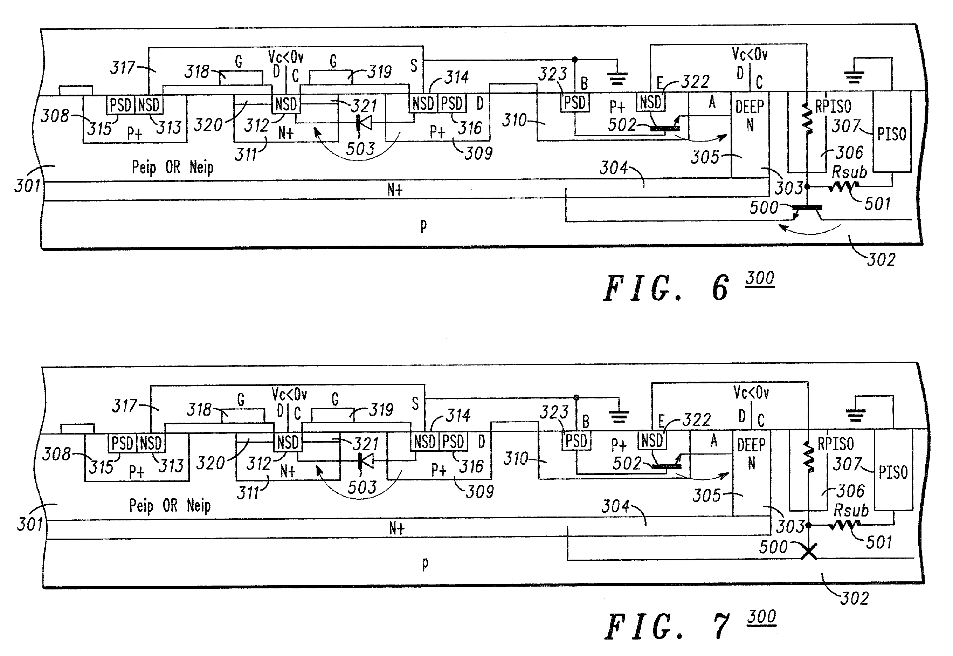

When the drain voltage is between 0 volts and -0.6 volts the body diode 503 becomes forward biased causing a current to flow from the source to the drain and a current to flow in the protective transistor 502 from the emitter to the collector thereby biasing the parasitic transistor 500, however, as the protective device is not operating in a saturated mode a small current will also flow from the victim (i.e. the collector) to the emitter of the parasitic transistor 500, as shown in figure 6.

When the drain voltage is between -0.6 volts and -1.0 volts the body diode 503 remains forward biased with an increased current flow from the source to the drain and with an increased current flow in the protective transistor 502 from the emitter to the collector. In this voltage range the protective transistor 502 operates in a saturated mode such that the biasing of the protective transistor 502 on the parasitic transistor 500 causes the parasitic transistor 500 to switch off, as shown in figure 7.

When the drain voltage is between -1.0 volts and -2.0 volts the body diode 503 still remains forward biased with a further increase in current flow from the source to the drain, as shown in figure 8. This regime corresponds to a high-injection current one that induces a significant voltage drop over the first Piso region 306, making the P-substrate 302 voltage increase and allowing again the turn-on of the NPN parasitic transistor 500.

With the protective transistor 502 being configured such that the emitter of the protective transistor 502 is coupled to the base of the parasitic transistor 500 and the collector is coupled to the drain of the power transistor the protective transistor 502 also provides ESD protection to the semiconductor power device.

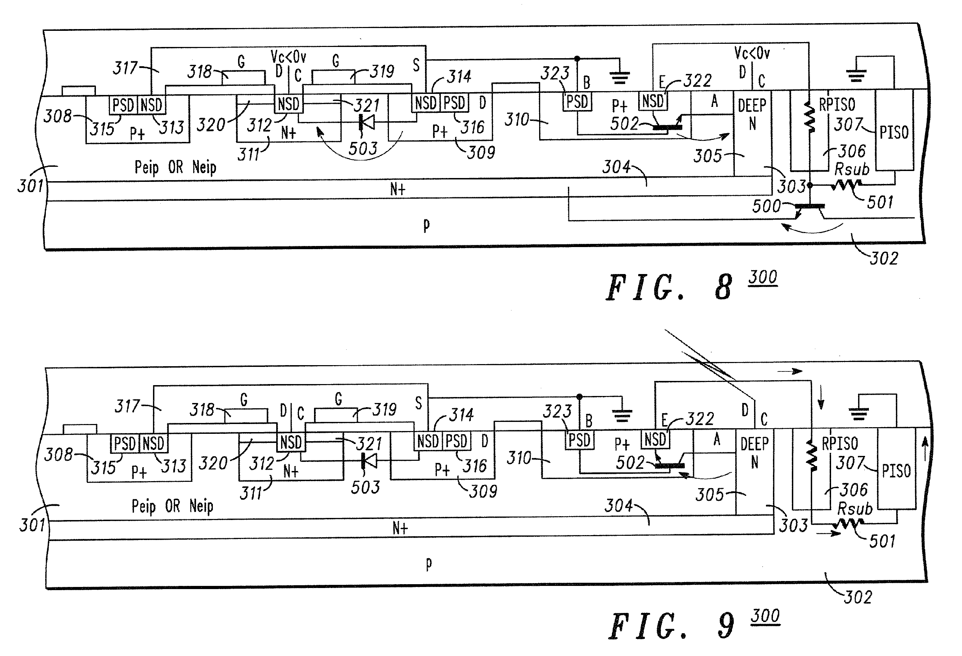

On the occurrence of an ESD event, causing an electro-static discharge to be conducted to the deep drain 305 of the power transistor (i.e. the collector of the protective transistor 502), an electro-static current, resulting from the ESD event, is discharged through the emitter of the protective transistor 502 to ground via the first Piso layer 306 and second Piso layer 307, as shown in figure 9. The level of ESD protection provided by the protective transistor 502 is governed by the distance L between the third P+ well region 310 and the deep drain region 305, which determines the voltage clamp value, in addition to the P substrate resistance Rsub due to the distance between the first Piso layer 306 and the second Piso layer 307.

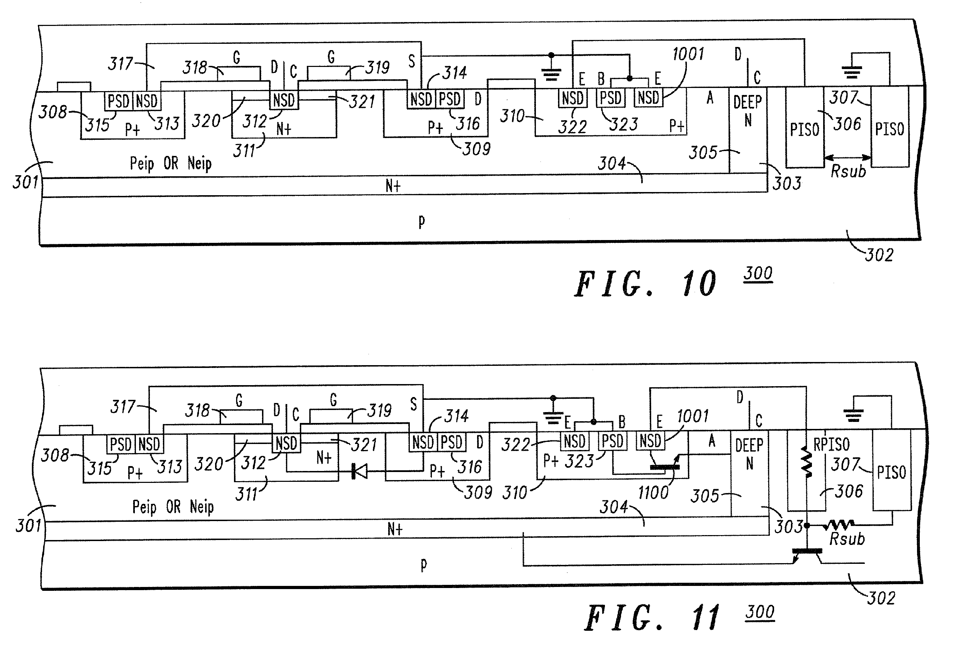

Figure 10 shows an alternative embodiment for a semiconductor power device 300 where the equivalent regions and elements have been given the same references to those show in previous figures. The semiconductor power device 300 shown in figure 10 is the same as the semiconductor power device shown in figure 3 other than the third P+ well region has two NSD regions 322, 1001 that both form the emitter of a protective transistor 502, where one NSD region 322 is coupled to the first Piso region 306 and the second NSD region 1001 is coupled directly to ground.

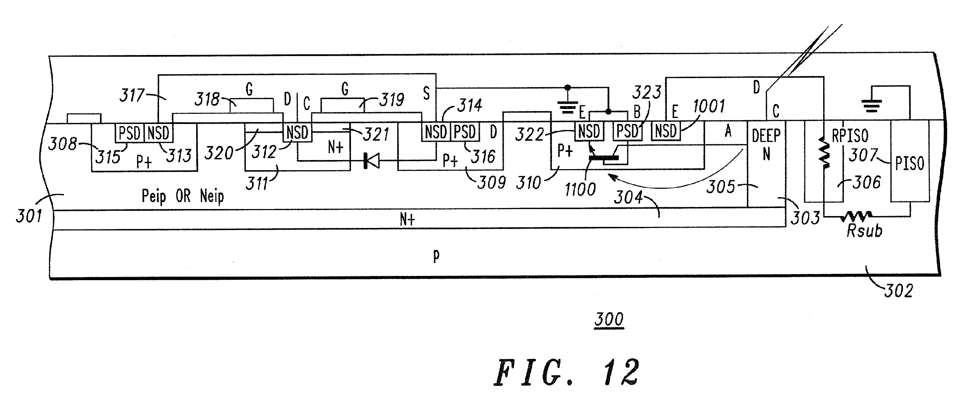

The first NSD region 322 of the third P+ well region 310 forms a first protective transistor 1100 that operates in the same manner as the protective transistor 502 shown in figure 3 during the period when the drain voltage goes below a reference voltage, as shown in figure 11.

The second NSD region 1001 of the third P+ well region 310 forms a second protective transistor that operates to provide ESD protection when an electro-static discharge is applied to the deep drain region 305 of the power transistor 300. The electro-static discharge causes the second protective transistor 1100 to switch on to allow an electro-static current to discharge through the second protective transistor 1100 to ground, as shown in figure 12. The level of ESD protection provided by the second protective transistor 1100 is also governed by the distance between the third P+ well region 310 and the deep drain region 305, which determines the voltage clamp value.

It will be apparent to those skilled in the art that the disclosed subject matter may be modified in numerous ways and may assume many embodiments other than the preferred forms specifically set out as described above, for example the above embodiments are based upon a semiconductor MOS power device having a single power transistor and a single protective bipolar transistor, however a power device may have a plurality of power transistors and/or a plurality of protective bipolar transistors.

## Claims

1. A semiconductor MOS power device comprising an epitaxial layer formed over a substrate; a first drain region formed by a buried layer located at the interface of the substrate and the epitaxial layer and a deep diffusion extending from the surface of the epitaxial layer to the buried layer to define an island region within the epitaxial layer; a second drain region formed in the island region; a source region of a first conductivity type formed in a first well region of a second conductivity type wherein the first well region is formed in the island region; a gate electrode formed above the island region; and an emitter region of the first conductivity type formed in a second well region of the second conductivity type wherein the second well region is formed in the island region; wherein the first drain region, the second drain region, the source region and the gate electrode form a power transistor and the emitter region forms an emitter of a protective bipolar transistor.

2. A semiconductor power device according to claim 1, wherein the first drain region of the power transistor forms a collector of the protective bipolar transistor.

3. A semiconductor power device according to any preceding claim, wherein the second well region forms a base of the protective bipolar transistor.

4. A semiconductor power device according to any preceding claim, wherein the emitter and collector of the bipolar transistor are arranged to provide electro-static discharge protection to the power device through the resistive path formed between the emitter and collector.

5. A semiconductor MOS power device comprising an isolation section forming a power transistor for driving an inductive load and a bipolar transistor for protecting the power device, the power transistor having a first semiconductor region for coupling to the inductive load, the first region arranged to form a PN junction with a second region and wherein the bipolar transistor is arranged to divert current from a third region that forms a PN junction with the second region upon forward biasing of the PN junction formed between the first region and the second region.

6. A semiconductor power device according to claim 5, wherein the first region of the power transistor forms a collector of the bipolar transistor.

7. A semiconductor power device according to claim 5 or 6, wherein the first region of the power transistor forms a drain of the power transistor.

8. A semiconductor power device according to any claims 5 to 7, wherein an emitter of the bipolar transistor forms a PN junction with the second region of the power transistor.

9. A semiconductor power device according to any of claims 5 to 8, wherein the emitter and collector of the bipolar transistor are arranged to provide electro-static discharge protection to the power device through the resistive path formed between the emitter and collector.
